# EUROPÄISCHE PATENTSCHRIFT

(11) **EP 0 876 743 B1**
(45) Veröffentlichungstag und Bekanntmachung des Hinweises auf die Patenterteilung: **06.10.1999**
(21) Anmeldenummer: 97915259.2
(22) Anmeldetag: 20.01.1997
(51) Int. Cl.: H05K 5/00, B60R 16/02

(54) **STEUERGERÄT, INSBESONDERE FÜR EIN KRAFTFAHRZEUG**
CONTROL DEVICE, ESPECIALLY FOR A MOTOR VEHICLE
DISPOSITIF DE COMMANDE, NOTAMMENT POUR AUTOMOBILE

(30) Priorität: 25.01.1996 DE 19602637; 19.12.1996 DE 29622097 U
(43) Veröffentlichungstag der Anmeldung: 11.11.1998
(73) Patentinhaber: SIEMENS AKTIENGESELLSCHAFT, 80333 München (DE)
(72) Erfinder: KERNER, Nikolaus, D-93173 Wenzenbach (DE); OTT, Reinhold, D-93142 Maxhütte-Haidhof (DE); VOGL, Günter, D-92711 Parkstein (DE)
(86) Internationale Anmeldenummer: DE9700089
(87) Internationale Veröffentlichungsnummer: WO9727728

(56) Entgegenhaltungen:
- EP-A- 0 708 583
- DE-A- 4 102 265
- DE-A- 4 240 754

## Beschreibung

Die Erfindung betrifft ein Steuergerät gemäß dem Oberbegriff von Patentanspruch 1.

Ein solches Steuergerät ist aus der Druckschrift DE 42 40 754 Al bekannt. Eine doppel-T-förmige Kühlplatte bildet zwei Außenwände des Gehäuses und ein Steckerteil eine weitere. Die Kühlplatte und das Steckerteil werden durch zwei Deckel zusammengehalten.

Aus der Druckschrift DE 41 02 265 A1 ist ein Steuergerät bekannt, dessen Gehäuse durch eine Kühlplatte und ein Gehäuseoberteil gebildet wird. Im Inneren des Gehäuses ist eine eine elektrische Schaltung tragende Leiterplatte auf der Oberseite der Kühlplatte angeordnet. Ein Steckerteil mit Steckerstiften ist unterhalb der Kühlplatte an dieser angebracht. Die Stekkerstifte ragen durch eine Öffnung der Kühlplatte und sind in die über die Öffnung gespannte Leiterplatte geführt, sodaß Steckerstifte und Schaltung elektrisch leitend verbunden sind.

Dieses Steuergerät erlaubt nur eine beschränkte Anzahl an Steckerstiften, da der zur Aufnahme der Steckerstifte vorgesehene und über der Öffnung der Kühlplatte angeordnete Bereich der Leiterplatte für die eigentliche elektrische Schaltung verloren geht. Daher erzwingt eine große Anzahl von Steckerstiften eine flächenmäßig große Leiterplatte und damit ein Steuergerät mit großen Abmessungen, was bei dem Einbauort Kraftfahrzeug mit seinem beschränkten Raumangebot von Nachteil ist. Ermöglicht die fortschreitende Technik eine kleinere Leiterplatte bei unverändertem Schaltungsumfang und gleichbleibender Anzahl von Steckerstiften, verringern sich jedoch die Steuergeräteabmessungen nur geringfügig, da ein relativ großer Bereich der Leiterplatte zur Aufnahme der Steckerstifte bereitgestellt werden muß und dieser Bereich nicht verkleinert werden kann. Ferner ist die Lage des Stekkerteils zur Leiterplatte festgelegt.

Auch unter dem Gesichtspunkt der elektromagnetischen Verträglichkeit ist das bekannte Steuergerätekonzept von Nachteil, da elektromagnetische Strahlung über die Steckerstifte durch die Öffnung der Kühlplatte direkt auf die Leiterplatte abgegeben wird. Schwach und stark abstrahlende Signalpfade können erst auf der Leiterplatte räumlich voneinander getrennt werden. Zudem sind die Steckerstifte in den mittleren Bereich der Leiterplatte geführt, was eine Rundumabstrahlung von elektromagnetischen Wellen auf die gesamte Schaltung zur Folge hat.

Aufgabe der Erfindung ist es, ein Steuergerät zu schaffen, das kompakt in seinen Abmessungen ist, und das ein oder mehrere Steckerteile auch mit einer großen Anzahl von Steckerstiften bei einer geringen flächenmäßigen Ausdehnung der die Schaltung tragenden Leiterplatte aufnehmen kann.

Die Aufgabe wird erfindungsgemäß durch die Merkmale des Patentanspruchs 1 gelöst. Dabei ist eine zweite Leiterplatte unterhalb der Kühlplatte angeordnet. Die Steckerstifte sind elektrisch mit der zweiten Leiterplatte verbunden. Die zweite Leiterplatte ist mit der ersten Leiterplatte über Verbindungselemente elektrisch leitend verbunden.

Diejenige Breitseite der Kühlplatte, auf der sie erste Leiterplatte angeordnet ist, wird im folgenden "Oberseite" genannt. Die andere Breitseite der Kühlplatte wird im folgenden "Unterseite" genannt. Die räumlichen Bestimmungen "oberhalb" und "unterhalb" der Kühlplatte sind entsprechend verwendet.

Die erfindungsgemäße Lösung hat den Vorteil, daß das Steuergerät zur Unterseite seiner Kühlplatte ein oder mehrere Stekkerteile auch mit einer großen Anzahl von Steckerstiften aufweisen kann. Die Größe der Kühlplatte richtet sich nach der Größe der ersten Leiterplatte und damit dem Umfang der elektrischen Schaltung oder nach der für die Steckerteile benötigten Fläche, ohne daß diese beiden Einflußgrößen miteinander korreliert sind.

Vorzugsweise ist das Steckerteil an einem Gehäuseunterteil angeordnet, das die zweite Leiterplatte aufnimmt, und das mit der Kühlplatte oder mit dem Gehäuseoberteil mechanisch verbunden ist. Die Steckerstifte sind in die zweite Leiterplatte geführt und über die Verbindungselemente elektrisch leitend mit der ersten Leiterplatte verbunden.
Weitere Vorteile des erfindungsgemäßen Steuergeräts sind in der Figurenbeschreibung offenbart.

Vorteilhafte Weiterbildungen der Erfindung sind in den Unteransprüchen gekennzeichnet.

Die Erfindung und ihre Weiterbildungen werden anhand der Zeichnungen erläutert. Es zeigen:
- Figur 1:: einen Längsschnitt durch ein erfindungsgemäßes Steuergerät,
- Figur 2:: ein Gehäuseunterteil in perspektivischer Ansicht von unten,
- Figur 3:: einen abgebrochenen Längsschnitt durch ein Steuergerät,
- Figur 4:: einen weiteren abgebrochenen Längsschnitt durch ein Steuergerät,
- Figur 5:: eine perspektivische Ansicht eines in verschiedenen Ebenen aufgebrochenen Steuergeräts von oben,
- Figur 6:: eine Explosionsdarstellung eines Steuergeräts,
- Figur 7:: eine Explosionsdarstellung von Bestandteilen eines Steuergeräts,
- Figur 8:: einen weiteren Längsschnitt durch ein Steuergerät, und
- Figur 9:: einen Querschnitt durch ein weiteres erfindungsgemäße Steuergerät.

Gleiche Elemente in den Figuren weisen figurenübergreifend dieselben Bezugszeichen auf.

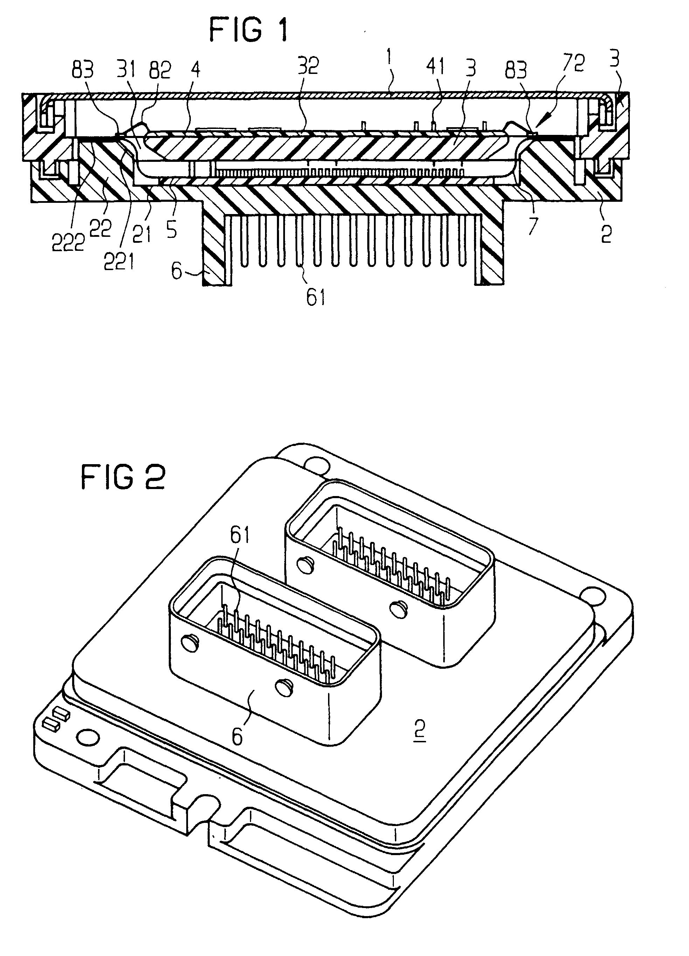

Figur 1 zeigt ein erfindungsgemäßes Steuergerät in einem Längsschnitt mit einem Gehäuseoberteil 1, einem Gehäuseunterteil 2, und einer Kühlplatte 3 zwischen Gehäuseoberteil 1 und Gehäuseunterteil 2. Unterhalb der Kühlplatte ist ein Steckerteil 6 mit Steckerstiften 61 angeordnet. Auf der Kühlplatte 3 ist eine eine elektrische Schaltung mit Bauelementen 41 tragende erste Leiterplatte 4 aufgebracht. Zur Unterseite der Kühlplatte 3 und über dem Steckerteil 6 ist eine zweite Leiterplatte 5 auf der Innenseite 21 des Gehäuseunterteils 2 aufgebracht. Zwei Verbinderteile 7 sind einstückig mit der zweiten Leiterplatte 5 verbunden und enthalten Bereiche 72 mit Kontaktflächen 83. Die Kontaktflächen 83 sind über Bonddrähte 82 mit der ersten Leiterplatte 4 verbunden. Das Gehäuseunterteil 2 enthält Stege 22 mit Rampen 221 und Stirnseiten 222, wobei die Bereiche 72 des Verbinders mit den Kontaktflächen auf den Stirnseiten 222 der Stege 22 angeordnet sind. Die Stege 22 ragen durch Öffnungen 31 der Kühlplatte 3.

Die Kühlplatte 3 ist als Metallplatte z. B. aus Aluminium, als Blech, oder als Druckguß- oder Stanzprägeteil aus Metall ausgebildet und dient zur Kühlung der elektrischen Bauelemente 41 auf der Leiterplatte 4, insbesondere aber auch zur Kühlung von in Figur 1 nicht eingezeichneten Leistungsbauelementen, die auf der Leiterplatte 4, besser aber noch direkt auf der Kühlplatte 3 oder über wärmeleitende Bauelementehalter auf der Kühlplatte 3 angeordnet sind. Zum zweiten schützt die Kühlplatte 3 die elektrische Schaltung auf der Leiterplatte 4 vor elektromagnetischer Einstrahlung (EMV-Strahlung). Dabei bildet die Kühlplatte 3 mit dem aus Metall bestehenden Gehäuseoberteil 1 eine nahezu geschlossene, EMV-schirmende Gehäusekammer 1,3 aus Metall. Gehäuseoberteil 1 und Kühlplatte 3 sind dabei in einer herkömmlichen Verbindungstechnik wie Crimpen, Bördeln, Kleben, Schrauben mechanisch miteinander verbunden.

Die erste Leiterplatte 4 kann als herkömmliche Ein- oder Mehrlagen-Leiterplatte oder als flexible Leiterplatte mit einem elektrisch isolierenden aber gut wärmeleitenden Kleber auf die Kühlplatte 3 geklebt oder laminiert werden. Die erste Leiterplatte 4 kann auch eine Hybridschaltung tragen.

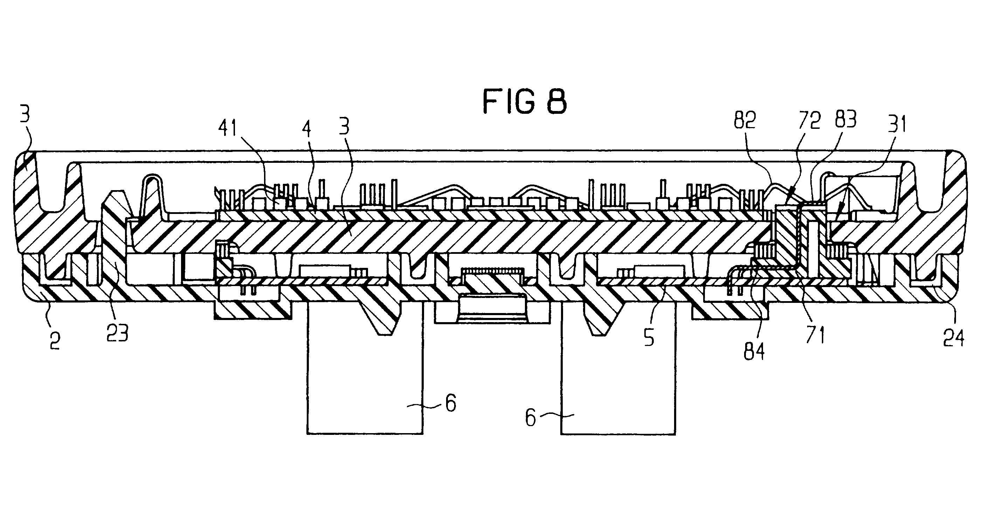

Das Gehäuseunterteil 2 ist vorzugsweise einstückig mit dem Steckerteil 6 aus Kunststoff hergestellt (gespritzt). Die Stege 22 sind dabei ebenfalls einstückig mit dem Gehäuseunterteil 2 ausgebildet. Die Steckerstifte 61 werden in demselben Herstellungsschritt umspritzt oder eingeschossen. Das Gehäuseunterteil 2 ist in einer bekannten Verbindungstechnik - z.B. mit einer kombinierten Schnapp- und Klebeverbindung (siehe Rasthaken 23 und Vergußmasse 24 in Figur 8) mit der Kühlplatte 3 verbunden. Die Kühlplatte 3 weist dazu an ihrem Umfang entsprechende Konturen auf. Gehäuseunterteil 2, Gehäuseoberteil 1 und Metallplatte sind zu einem wasserdichten Gehäuse verbunden.

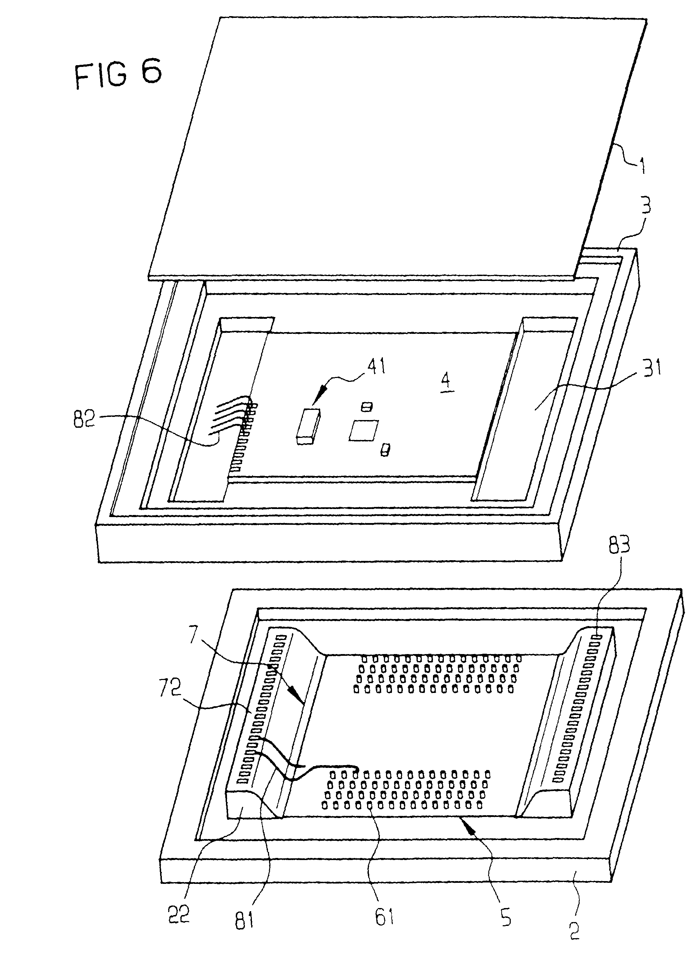

Die zweite Leiterplatte 5 ist auf die Innenseite 21 des Gehäuseunterteils 2 aufgeklebt. Sie ist zusammen mit den Verbinderteilen 7 einstückig als flexible Leiterplatte ausgebildet und mit ihren Enden auf den Stirnseiten 222 der Stege 22 befestigt. Die Steckerstifte 61 sind in die flexible Leiterplatte 5,7 geführt und werden auf der Oberseite der flexiblen Leiterplatte 5,7 mit dieser verlötet. Wie aus Figur 5 ersichtlich ist, weist die flexible Leiterplatte 5,7 Leiterbahnen 81 auf, die von den Steckerstiften 61 zu den Kontaktflächen 83 geführt sind. Die Kontaktflächen 83 sind mit Hilfe der Stege 22 auf einer Höhe mit der ersten Leiterplatte 1 angeordnet und über Bonddrähte mit dieser verbunden. Damit sind die Steckerstifte 61 über die Leiterbahnen 81, die Kontaktflächen 83 und die Bonddrähte 82 als Verbindungselemente 8 elektrisch leitend mit der ersten Leiterplatte 4 verbunden.

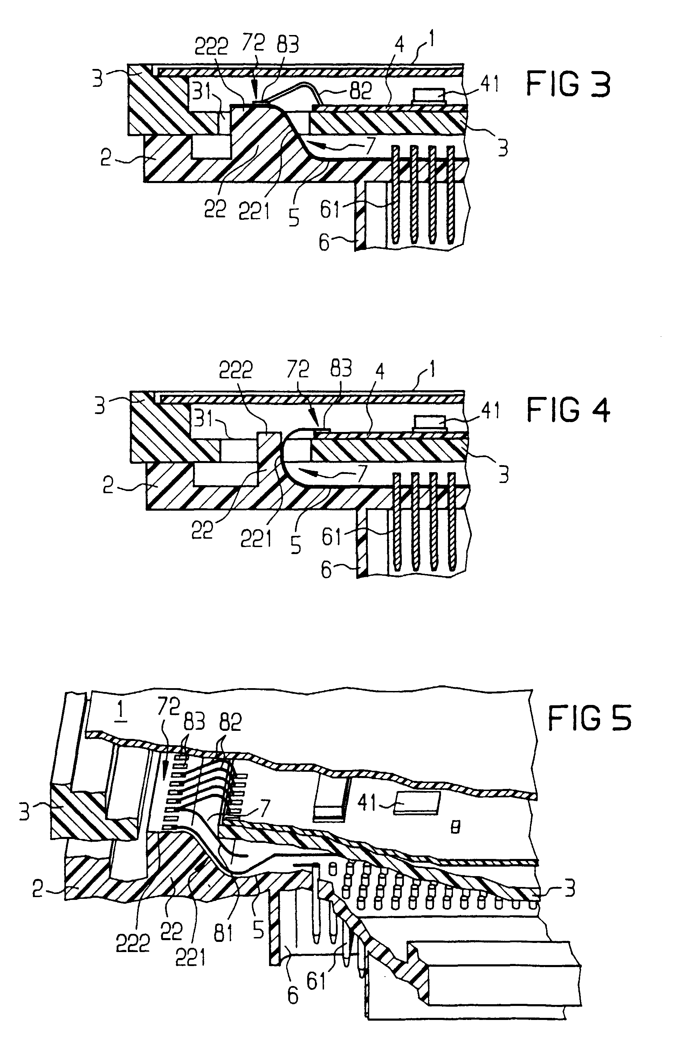

Figur 3 zeigt einen abgebrochenen Längsschnitt des erfindungsgemäßen Steuergeräts, das sich von Figur 1 im wesentlichen darin unterscheidet, daß die flexible Leiterplatte 5,7 über angeschrägte Rampen 221 der Stege 22 zu deren Stirnseiten 222 geführt ist.

Figur 4 zeigt eine weitere Variante der Verbindung zwischen der zweiten und der ersten Leiterplatte 5 und 4: Die flexible Leiterplatte 5,7 wird entlang der Rampen 221 durch die Öffnungen 31 der Kühlplatte 3 geführt, mit ihren Enden dann aber nicht auf den Stirnseiten 222 der Stege 22 befestigt sondern auf die erste Leiterplatte 1 umgeklappt, so daß zumindest der Bereich 72 mit den Kontaktflächen 83 auf der ersten Leiterplatte 4 aufliegt. Die Kontaktflächen 83 werden durch Löten oder mit Leitkleber mit entsprechenden Kontaktstellen der ersten Leiterplatte 4 elektrisch leitend verbunden, so daß wiederum eine elektrisch leitende Verbindung von den Steckerstiften 61 über die Leiterbahnen 81 und die Kontaktflächen 83 zur ersten Leiterplatte 4 hergestellt ist.

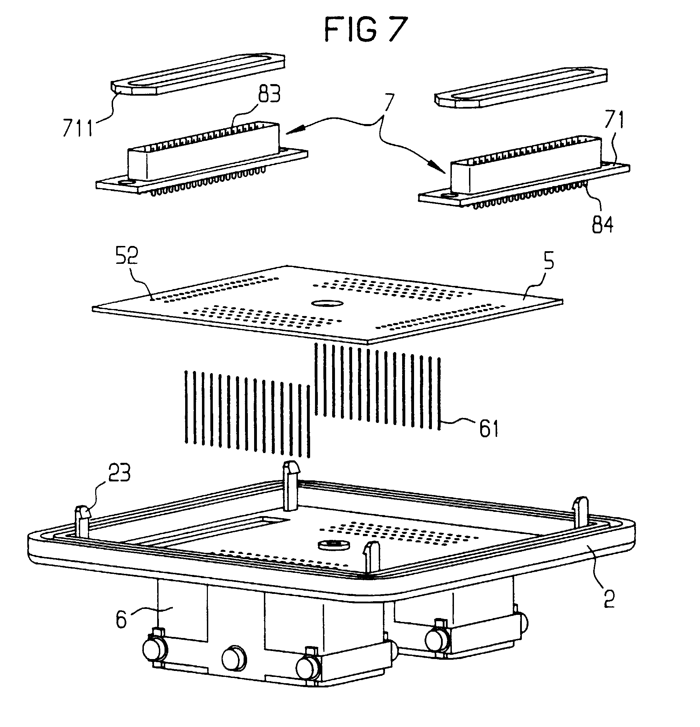

Figur 7 zeigt in einer Explosionsdarstellung eine weitere Variante der Verbindung zwischen zweiter und erster Leiterplatte 5 und 4 mit denjenigen Elementen des Steuergeräts, die zur Unterseite der Kühlplatte 3 angeordnet sind: Die zweite Leiterplatte 5 ist als starre Leiterplatte ausgebildet. Anstelle der starren Leiterplatte kann weiterhin eine flexible Leiterplatte vorgesehen sein. Nicht gezeigte Leiterbahnen der zweiten Leiterplatte 5 verbinden die im zusammengebauten Zustand in die zweite Leiterplatte 5 geführten Steckerstifte 61 mit Steckplätzen 52 elektrisch. In diese Steckplätze 52 werden als Kontaktleisten 71 ausgebildete Verbinderteile 7 gesteckt und mit den Leiterbahnen der zweiten Leiterplatte 5 verlötet. Die Kontaktleisten 71 enthalten umspritzte Kontaktstifte 84, die ggf. als Stanz-Biegeteile ausgebildet sind. Auf der Stirnseite der Kontaktleisten sind Kontaktflächen 83 angeordnet. Bei zusammengebautem Steuergerät ragen die Kontaktleisten durch die Öffnung 31 der Kühlplatte 3, wobei auch bei diesem Ausführungsbeispiel die Kontaktflächen 83 in einer Ebene mit der ersten Leiterplatte 4 angeordnet sind, so daß in einer Ebene von den Kontaktflächen 83 zur ersten Leiterplatte 4 gebondet werden kann.

Figur 8 zeigt einen Längsschnitt eines solchen Steuergeräts mit Kontaktleisten 71 als Verbinderteile 7.

Die Kontaktleiste können auch Γ-förmig ausgebildet sein, sodaß die Kontaktleiste mit der Unterseite des Längsbalkens in den Steckplatz der zweiten Leiterplatte geführt wird. Auf der Unterseite des Querbalkens sind dann die Kontaktflächen aufgebracht. Beim Aufsetzen einer solchen Kontaktleiste sind die Kontaktflächen von oben auf entsprechenden Kontaktstellen der ersten Leiterplatte geführt und mit diesen elektrisch verbunden (entsprechend Figur 4).

Die mechanische Verbindung zwischen zweiter Leiterplatte 5 und Gehäuseunterteil 2 kann beliebig ausgestaltet sein, z. B. durch Nieten, Dome, Kleber oder Schrauben.

Bei einem Steckerteil mit großen Abmessungen kann die zweite Leiterplatte unter Umständen in ihrer ganzen Ausdehnung über dem Steckerteil angeordnet sein, so daß bei dieser Ausführungsform Gehäuseunterteil und Steckerteil eine Einheit bilden. Das Gehäuseunterteil bildet auch hier zusammen mit der Kühlplatte eine Gehäusekammer zur Aufnahme der zweiten Leiterplatte.

Figur 2 zeigt ein Gehäuseunterteil 2 in perspektivischer Ansicht von unten, das zwei Steckerteile 61 aufweist.

Figur 6 zeigt eine Explosionsdarstellung des Steuergeräts gemäß Figur 1, das zwei Öffnungen 31 im Randbereich der Kühlplatte 3 aufweist. Es ist vorteilhaft, diese Öffnungen 31 aufgrund der über die Verbindungselemente 8 in die Gehäusekammer 1,3 transportierten EMV-Strahlung im Randbereich der Kühlplatte 3 anzubringen. Je nach Anzahl der Steckerstifte 61 kann die Kühlplatte 3 eine, zwei, drei oder vier Öffnungen aufweisen, wobei in einer Ausführungsform mit vier Öffnungen 31 die erste Leiterplatte 4 vorzugsweise von diesen vier Öffnungen 31 umgeben wird.

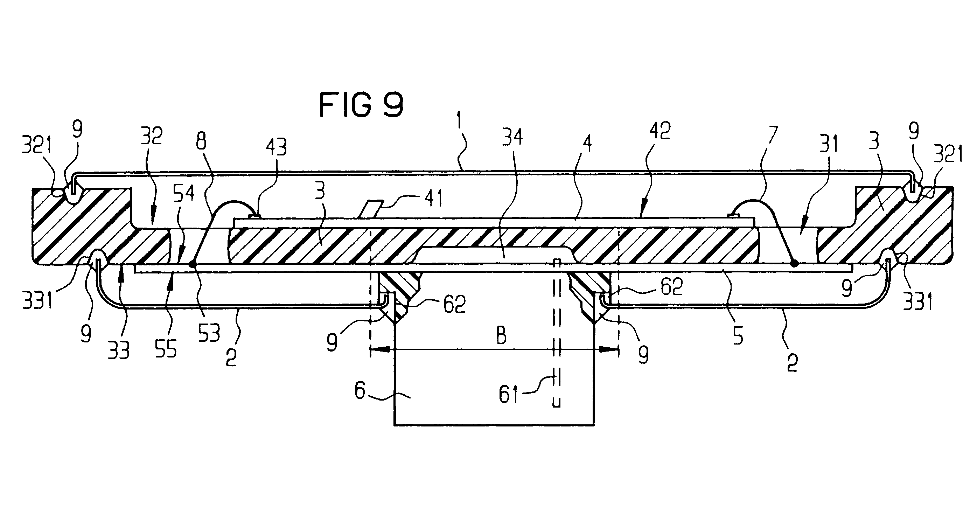

Die Figur 9 zeigt einen Längsschnitt durch ein weiteres erfindungsgemäßes Steuergerät mit einem Gehäuseoberteil 1, einem Gehäuseunterteil 2, und einer Kühlplatte 3 zwischen Gehäuseoberteil 1 und Gehäuseunterteil 2. Unterhalb der Kühlplatte 3 ist ein Steckerteil 6 mit gestrichelt angedeuteten Steckerstiften 61 angeordnet. Eine eine elektrische Schaltung mit Bauelementen 41 tragende erste Leiterplatte 4 ist mechanisch fest mit der Oberseite 32 der Kühlplatte 3 verbunden. Auf der Unterseite 33 der Kühlplatte 3 zwischen Kühlplatte 3 und Steckerteil 6 ist eine zweite Leiterplatte 5 aufgebracht. Erste Leiterplatte 4 und zweite Leiterplatte 5 sind über als Bonddrähte ausgebildete Verbindungselemente 7 elektrisch miteinander verbunden.

Die erste Leiterplatte 4 kann als herkömmliche Ein- oder Mehrlagen-Leiterplatte oder als flexible Leiterplatte mit einer elektrisch isolierenden aber gut wärmeleitenden Klebeschicht auf die Kühlplatte 3 geklebt oder laminiert werden. Die erste Leiterplatte 4 ist auch hier allgemein als Schaltungsträger zu verstehen, der insbesondere eine Schaltung zur Motor- oder Getriebesteuerung für ein Kraftfahrzeug trägt. Dieser Schaltungsträger ist vorzugsweise als Hybridschaltungsträger ausgebildet, weist also einen Keramiksockel auf.

Die zweite Leiterplatte 5 ist in Figur 9 vorzugsweise als starre, herkömmliche Kunststoff-Leiterplatte ausgebildet, die auf die Kühlplatte 3 aufgeklebt oder auflaminiert ist. Dabei ist nicht erforderlich, daß die gesamte Leiterplattenfläche in Kontakt zum Kühlkörper steht. Durch das Aufbringen bzw feste Verbinden der zweiten Leiterplatte mit dem Kühlkörper werden am Steckteil 6 eingeleitete Kräfte, die etwa durch einen mit dem Steckerteil verbundenen mitschwingenenden Kabelbaum im Kraftfahrzeug verursacht sind, nicht auf die elektrischen Verbindungselemente 7 übertragen. Dazu ist das Steckerteil 6 vorzugsweise mechanisch nicht mit der zweiten Leiterplatte verbunden - abgesehen von den elektrischen Kontaktstellen. Ggf über die elektrischen Kontaktstellen auf die zweite Leiterplatte 5 eingeleitete Kräfte werden infolge der festen mechnischen Verbindung zwischen der zweiten Leiterplatte 5 und der Kühlplatte 3 nicht auf die für mechanische Beanspruchung empfindlichen und bruchgefährdeten Verbindungselemente 7 zwischen erster und zweiter Leiterplatte 4 und 5 übertragen. Damit wird das Steuergerät zuverlässiger.

Die Steckerstifte 61 sind in die zweite Leiterplatte 5 geführt bzw eingepreßt und ggf auf deren Oberseite 52 mit dieser verlötet. Zur Aufnahme der aus der Oberseite der zweiten Leiterplatte 5 hervorragenden Steckerstiftspiten weist die Kühlplatte 3 eine Aussparung 34 auf. Die zweite Leiterplatte 5 überdeckt im Gegensatz zur ersten Leiterplatte 4 Öffnungen 31 der Kühlplatte 3. Die zweite Leiterplatte 5 weist nicht eingezeichnete Leiterbahnen auf, die von den Steckerstiften 61 zu Kontaktflächen 51 geführt sind, die im Bereich der Öffnungen 31 auf der Oberseite 52 der zweiten Leiterplatte 5 angeordnet sind.

Sind die Steckerstifte 61 auf der Oberseite 52 der zweiten Leiterplatte 5 mit dieser verlötet und ist beispielsweise die zweite Leiterplatte 5 als einlagige Leiterplatte mit Leiterbahnen auf ihrer Oberseite 52 ausgebildet, so weist die zweite Leiterplatte 5 zumindest in dem Bereich, in dem sie mit ihrer Oberseite 52 auf der Unterseite 33 der Kühlplatte 3 befestigt ist, eine Isolierschicht auf ihrer Oberseite 52 auf. Alternativ ist die zweite Leiterplatte 5 als mehrlagige Leiterplatte ausgebildet. Vorteilhaft ist insbesondere auch eine Ausbildung des Steckerteils 6 als oberflächenmontierbares SMD-Steckerteil. Damit sind die Steckerstifte 61 auf der Unterseite 53 der zweiten Leiterplatte 5 mit dieser verlötet oder verklebt. Die zweite Leiterplatte 5 weist dann vorzugsweise Leiterbahnen auf ihrer Unterseite 53 auf. Von den Kontaktflächen 51 auf der Oberseite 52 der zweiten Leiterplatte 5 erfolgt dann eine Durchkontaktierung zu den Leiterbahnen auf der Unterseite 53.

Zumindest einige der Steckerstifte 61 sind über die Leiterbahnen der zweiten Leiterplatte 5, die Kontaktflächen 53 der zweiten Leiterplatte 5 und die Verbindungselemente 7 elektrisch leitend direkt mit den Kontaktflächen 43 der ersten Leiterplatte 4 verbunden. Auf der zweiten Leiterplatte 5 können aber auch elektrische Bauelemente angeordnet sein, wobei die über die Steckerstifte 61 zugeführten Signale durch diese Bauelemente im wesentlichen vorverarbeitet werden und erst dann der Schaltung auf der ersten Leiterplatte 4 zugeführt werden.

Die Verbindungselemente 7 sind insbesondere als Bonddrähte zwischen den Kontaktflächen 51 auf der zweiten Leiterplatte 5 und Kontaktflächen 43 auf der Oberseite 42 der ersten Leiterplatte 4 ausgebildet. Insbesondere bei einem Hybridschaltungsträger als erster Leiterplatte 4 sind Bonddrähte als Verbindungselemente 7 vorteilhaft.

Es können aber auch andere Verbindungselemente 7 verwendet werden, beispielsweise Kontaktleisten gemäß Figur 7.

Das Steckerteil 6 ist mit Nieten, Schrauben oder durch Verstemmen oder Verkleben mit der Kühlplatte 3 verbunden. Die Befestigungsmittel können dabei durch Aussparungen der zweiten Leiterplatte 5 geführt sein oder neben der zweiten Leiterplatte 5 angeordnet sein. Erfindungsgemäß ist das Steckerteil 6 in einem Bereich B an der Kühlplatte 3 befestigt, der durch die elektrischen Kontaktstellen zwischen den Steckerstiften 61 und der zweiten Leiterplatte 5 gekennzeichnet ist, wodurch die Verbindung zwischen Steckerteil 6 und Kühlplatte 3 rüttelfest ausgebildet ist. Durch diese mechanische Befestigung werden am Steckteil 6 eingeleitete Kräfte, die etwa durch einen mit dem Steckerteil 6 verbundenen mitschwingenenden Kabelbaum im Kraftfahrzeug verursacht sind, unmittelbar an ihrer Einleitungsstelle - eben dem Steckerteil 6 - abgefangen, ohne sich über weitere schwingungsfähige Steuergerätbestandteile fortpflanzen zu können. Um die Kontaktstellen zwischen den Steckerstiften 61 und der zweiten Leiterplatte 5 nicht zu belasten sind die Punkte - eben die Befestigungspunkte - , an denen Kräfte vom Steckerteil 6 auf die Kühlplatte 3 übertragen und abgefangen werden, nahe bei den Kontaktstellen angeordnet. Diese Kräfte werden nicht auf die zweite Leiterplatte 5 und die Verbindungselemente 7 weitergegeben. Insbesondere die dünndrahtigen bruchgefährdeten Bondverbindungen zwischen erster und zweiter Leiterplatte 4 und 5 sind selbst bei starken Vibrationen des Steckerteils 6 mechanisch entlastet. Das gesamte Steuergerät ist hinsichtlich einer möglichen Vibrationsbeanspruchung mechnisch steif ausgebildet und deshalb zuverlässig im Betrieb in rauher Umgebung wie etwa im Kraftfahrzeug.

Das Gehäuseunterteil 2 bildet zusammen mit der Kühlplatte 3 in etwa eine Kammer in der die zweite Leiterplatte 5 mit dem Steckerteil 6 angeordnet ist. Ist das Gehäuseunterteil 2 aus Metall hergestellt, so wird eine gute elektromagnetische Schirmung erzielt, da das gesamte Gehäuse bestehend aus Kühlplatte 3, Gehäuseoberteil 1 und Gehäuseunterteil 2 aus Metall hergestellt ist, sodaß die elektrische Schaltung und die Leiterbahnen im Gehäuseinneren gut geschirmt sind.

Bei einem Einsatz des Steuergeräts beispielsweise im Motorraum ist das Steuergerät insbesondere dicht zu gestalten: Dazu weist die Kühlplatte 3 an ihrer Ober-und Unterseite 32 und 33 Nuten 321 und 331 auf, die mit einer Dichtmasse 8 gefüllt sind. Der Rand des Gehäuseober- bzw unterteils 1 und 2 ist jeweils in die entsprechende Nut eingeführt. Auch Gehäuseunterteil 2 und Steckerteil 6 sind gegeneinander abgedichtet. Das Steckerteil 6 weist gemäß der Figur eine mit einer Dichtmasse 8 gefüllte Nut 62 auf, in die der entsprechende Rand des Gehäuseunterteils 2 eingreift.

Vorzugsweise ist das Steckerteil 6 mit dem Gehäuseunterteil 2 einstückig aus Kunststoff hergestellt, der ggf mit Metallpartikeln zur Verbesserung der elektromagnetischen Schirmung durchsetzt ist. In jedem Fall ist auch hier das eigentliche Steckerteil 6 mit fest mit der Kühlplatte 3 zu verbinden, insbesondere nahe an den Kontaktstellen zwischen Steckerstiften 61 und zweiter Leiterplatte 5.

Das erfindungsgemäße Steuergerätekonzept hat insbesondere folgende Vorteile:

Steckerteile können über die gesamte Grundfläche der Kühlplatte zu deren Unterseite angeordnet sein, bzw. ein Steckerteil mit einer großen Anzahl an Steckerstiften kann die gesamte Grundfläche der Kühlplatte für sich beanspruchen, ohne daß aufgrund der Anzahl der Steckerteile/Steckerstifte die erste Leiterplatte vergrößert werden muß.

Das Steckerteil kann an einer beliebigen Stelle auf der Unterseite der Kühlplatte angeordnet werden.

Das Steuergerät kann eine große Anzahl von Steckerstiften aufweisen, da die Steckerstifte zunächst mit den Leiterbahnen der zweiten Leiterplatte verbunden sind: Durch die kleinere Strukturgröße von Leiterbahnen, Kontaktstiften, Kontaktflächen und Bonddrähten als Verbindungselementen zwischen zweiter und erster Leiterplatte wird das grobe Raster der aufgrund ihrer mechanischen Beanspruchung dick ausgebildeten Steckerstifte in ein wesentlich feineres Anschlußraster der Kontaktflächen umgesetzt. Da die vorgenannten Verbindungselemente zwischen Steckerstiften und erster Leiterplatte mechanisch kaum beansprucht werden, können sie dünn ausgebildet sein.

Die Plazierung des Verbinderteils ist unabhängig von der Plazierung des Steckerteils: Insbesondere hinsichtlich der elektromagnetischen Schirmung wird daher das Verbinderteil vorzugsweise am Rand der elektrischen Schaltung/ersten Leiterplatte angeordnet, wohingegen das Steckerteil im mittleren Bereich der Kühlplatte unter derselben stabil angeordnet ist. Zum anderen müssen bei Verwendung eines anderen Steckerteils - z. B. mit anderer Signalbelegung der Steckerstifte oder einer größeren/kleineren Anzahl von Steckerstiften - oder einer Anordnung eines zusätzlichen Steckers lediglich die Leiterbahnführung auf der zweiten Leiterplatte und das Gehäuseunterteil/Steckerteil geändert werden: Die eigentliche elektrische Schaltung kann unverändert bleiben.

Die freie Wahl der Leiterbahnführung (Routing) auf der zweiten Leiterplatte gestattet eine EMV-gerechte Leiterbahnführung: So können bereits auf der zweiten Leiterplatte empfindliche Signalwege von stark abstrahlenden Signalwegen getrennt werden, wobei ggf. eine Masseleitung zwischen diesen Signalwegen zur Aufnahme von EMV-Strahlung angeordnet ist. EMV-empfindliche Leiterbahnen werden z. B. räumlich gruppiert über ein erstes Verbinderteil der ersten Leiterplatte zugeführt: Störanfällige Bauelemente sind dann nahe dem ersten Verbinderteil auf der ersten Leiterplatte angeordnet sind. Stark abstrahlende Leiterbahnen dagegen werden räumlich gruppiert über ein zweites Verbinderteil der ersten Leiterplatte zugeführt: Störunanfällige Bauelemente sind dann nahe dem zweiten Verbinderteil auf der ersten Leiterplatte angeordnet sind.

Durch die Kühlplatte und das Gehäuseoberteil wird eine nahegehend EMV-dichte Gehäusekammer geschaffen, in der die erste Leiterplatte mit der elektrischen Schaltung angeordnet ist. Zur weiteren Verbesserung der EMV-Eigenschaften des Steuergeräts kann über die Steckerstifte in das Steuergerät einfallende elektromagnetische Strahlung durch einen metallisierten Bereich auf der zweiten Leiterplatte bereits nahe am Steckerteil abgeleitet werden. Ist die zweite Leiterplatte als Mehrlagenleiterplatte ausgebildet, kann eine der Lagen den metallisierten Bereich enthalten.

Auf der zweiten Leiterplatte können auch elektrische Bauelemente angeordnet sein.

Eine Bondverbindung zwischen Kontaktflächen auf dem Verbinderteil und der ersten Leiterplatte ist insbesondere dann vorteilhaft, wenn die elektrische Schaltung als Hybridschaltkreis ausgebildet ist. Liegen die über Bonddrähte verbundenen Kontaktflächen auf dem Verbinderteil und entsprechenden Kontaktstellen auf der ersten Leiterplatte in einer Ebene (siehe Figur 3), so ist die Zugfestigkeit der Bondverbindung erhöht, da eine vertikale Beanspruchung der Bondverbindung nicht sofort zu einem Reißen der Bonddrähte führt, ebensowenig wie eine horizontale Beanspruchung. Damit können die Bonddrähte dünner ausgebildet werden; ferner sind sie erheblich kürzer als bei einer Bondverbindung zwischen Kontaktflächen auf unterschiedlichen Ebenen. Insgesamt ist die Bondverbindung damit zuverlässiger.

Bei dem erfindungsgemäßen Steuergerät ist auch genügend Raum zum Erstellen der Bondverbindungen vorgesehen: Gemäß Figur 3 ist zur linken Seite der Kontaktflächen 83 genügend Raum gegeben, sodaß ein Bondwerkzeug den Bonddraht an der Kontaktfläche 83 anbringen kann. Der linksseitige Raum der Kontaktfläche wird nicht durch Stecker oder sonstige Gehäusebestandteile versperrt. Zur rechten Seite der auf der ersten Leiterplatte angeordneten Kontaktstellen ist ebenfalls ausreichend Platz vorgesehen, sodaß das Bondwerkzeug überstehenden Bonddraht zur rechten Seite der Kontaktstellen hin abreißen kann. Auch hierbei wird der rechtsseitige Raum der Kontaktstellen nicht durch einen Stecker oder andere Gehäusebestandteile beeinträchtigt.

## Patentansprüche

1. Steuergerät, insbesondere für ein Kraftfahrzeug,
- mit einer Kühlplatte (3), auf deren Oberseite (32) eine erste Leiterplatte (4) mit einer elektrischen Schaltung angeordnet ist,
- mit einem Steckerteil (6) mit Steckerstiften (61),
- mit einer zweiten Leiterplatte (5), die auf der der ersten Leiterplatte (4) abgewandten Seite der Kühlplatte (3) angeordnet ist, und
- mit Verbindungselementen (8), über die die zweite Leiterplatte (5) mit der ersten Leiterplatte (4) elektrisch leitend verbunden ist,
**dadurch gekennzeichnet,**
- daß das Steckerteil (6) auf der der ersten Leiterplatte (4) abgewandten Seite der Kühlplatte (3) angeordnet ist,
- daß die zweite Leiterplatte (5) zwischen dem Steckerteil (6) und der Kühlplatte (3) angeordnet ist, und
- daß die Steckerstifte (61) in die zweite Leiterplatte (5) geführt und mit dieser elektrisch verbunden sind.

2. Steuergerät nach Anspruch 1, dadurch gekennzeichnet, daß die Steckerstifte (61) über Leiterbahnen (81) der zweiten Leiterplatte (5) und die Verbindungselemente (8) elektrisch leitend mit der ersten Leiterplatte (4) verbunden sind.

3. Steuergerät nach Anspruch 1, dadurch gekennzeichnet, daß die erste Leiterplatte (4) als Hybridschaltungsträger ausgebildet ist.

4. Steuergerät nach Anspruch 1, dadurch gekennzeichnet, daß die Kühlplatte (3) und ein Gehäuseoberteil (1) eine Gehäusekammer für die erste Leiterplatte (4) bilden.

5. Steuergerät nach Anspruch 1, dadurch gekennzeichnet, daß die Kühlplatte (3) und ein Gehäuseunterteil (2) eine Gehäusekammer für die zweite Leiterplatte (5) bilden.

6. Steuergerät nach Anspruch 1, dadurch gekennzeichnet, daß die Kühlplatte (3) eine von der ersten Leiterplatte (4) unbedeckte Öffnung (31) aufweist, durch die die Verbindungselemente (8) geführt sind.

7. Steuergerät nach Anspruch 1, dadurch gekennzeichnet, daß ein Verbinderteil (7) vorgesehen ist, das zumindest einen Abschnitt von elektrisch leitenden Verbindungselementen (8) enthält.

8. Steuergerät nach den Ansprüchen 6 und 7, dadurch gekennzeichnet, daß das Verbinderteil (7) in die Öffnung (31) ragt.

9. Steuergerät nach Anspruch 8, dadurch gekennzeichnet, daß das Verbinderteil (7) Kontaktflächen (83) aufweist, die in etwa in einer Ebene mit der ersten Leiterplatte (4) angeordnet sind, und die mit den Verbindungselementen (8) elektrisch verbunden sind.

10. Steuergerät nach Anspruch 9, dadurch gekennzeichnet, daß Bonddrähte (82) von den Kontaktflächen (83) auf die erste Leiterplatte (4) geführt sind.

11. Steuergerät nach Anspruch 5, dadurch gekennzeichnet, daß die zweite Leiterplatte (5) auf der Innenseite (21) des Gehäuseunterteils (2) angeordnet ist.

12. Steuergerät nach Anspruch 7, dadurch gekennzeichnet, daß das Verbinderteil (7) als Kontaktleiste (71) ausgebildet ist und Kontaktstifte (84) enthält, die mit der zweiten Leiterplatte (5) elektrisch verbunden sind.

13. Steuergerät nach Anspruch 7, dadurch gekennzeichnet, daß das Verbinderteil (7) und die zweite Leiterplatte (5) einstückig als flexible Leiterplatte (5,7) ausgebildet sind.

14. Steuergerät nach Anspruch 6 und 8, dadurch gekennzeichnet, daß das Gehäuseunterteil (2) im Bereich unterhalb der Öffnung (31) einen Steg (22) aufweist, und daß das Verbinderteil (7) zusammen mit dem Steg (22) durch die Öffnung (31) geführt ist.

15. Steuergerät nach Anspruch 8 und 14, dadurch gekennzeichnet, daß derjenige Bereich (72) des Verbinderteils (7), der die Kontaktflächen (83) enthält, auf der Stirnseite (222) des Stegs (22) angeordnet ist.

16. Steuergerät nach Anspruch 8 und 15 dadurch gekennzeichnet, daß das Verbinderteil (7) einen Bereich (72) mit Kontaktflächen aufweist, daß dieser Bereich (72) über der ersten Leiterplatte (4) angeordnet ist, und daß die Kontaktflächen (83) elektrisch leitend mit der ersten Leiterplatte (4) verbunden sind.

17. Steuergerät nach Anspruch 1, dadurch gekennzeichnet, daß das Gehäuseoberteil (1) zusammen mit der Kühlplatte (3) eine Gehäusekammer (1,3) bildet, daß das Steckerteil (6) elektrisch leitend mit der ersten Leiterplatte (4) verbunden ist, daß die Kühlplatte (3) zwischen dem Gehäuseoberteil (1) und einem Gehäuseunterteil (2) angeordnet ist, daß die zweite Leiterplatte (5) zwischen der Kühlplatte (3) und dem Gehäuseunterteil (2) angeordnet ist, daß das Steckerteil (6) unterhalb der zweiten Leiterplatte (5) am Gehäuseunterteil (2) angeordnet ist, und daß ein Verbinderteil (7) zumindest einen Abschnitt der elektrisch leitenden Verbindungselemente (8) enthält.

18. Steuergerät nach Anspruch 1, dadurch gekennzeichnet, daß die zweite Leiterplatte (5) auf der Unterseite (33) der Kühlplatte (3) angeordnet ist.

19. Steuergerät nach Anspruch 1, dadurch gekennzeichnet, daß das Steckerteil (6) fest mit der Kühlplatte (3) verbunden ist.

20. Steuergerät nach Anspruch 18, dadurch gekennzeichnet, daß das Steckerteil (6) in einem Bereich (B) fest mit der Kühlplatte (3) verbunden ist, der durch die elektrischen Kontaktstellen zwischen den Steckerstiften (61) und der zweiten Leiterplatte (5) gekennzeichnet ist.

21. Steuergerät nach Anspruch 1, dadurch gekennzeichnet, daß das Steckerteil (6) unmittelbar an der Kühlplatte (3) befestigt ist.

22. Steuergerät nach Anspruch 1, dadurch gekennzeichnet, daß die Verbindungselemente (8) als Bonddrähte ausgebildet sind.

23. Steuergerät nach Anspruch 18, dadurch gekennzeichnet, daß die Öffnung (31) von der zweiten Leiterplatte (5) bedeckt ist, und daß die Verbindungselemente (8) von Kontaktflächen (43) auf der Oberseite (42) der ersten Leiterplatte (4) auf Kontaktflächen (53) auf der Oberseite (54) der zweiten Leiterplatte (5) geführt sind.

24. Steuergerät nach Anspruch 18, dadurch gekennzeichnet, daß die Steckerstifte (61) in die zweite Leiterplatte (5) geführt sind und die Kühlplatte (3) in diesem Bereich (B) eine Aussparung (34) aufweist.

## Claims

1. Control unit, particularly for a motor vehicle,
- with a cooling plate (3) on whose upper side (32) a first wiring board (4) with an electrical circuit is mounted,
- with a connector section (6) with contact pins (61),
- with a second wiring board (5) which is mounted on the side of the cooling plate (3) opposed to the first wiring board (4), and
- with coupler elements (8) via which the second wiring board (5) is electrically connected to the first wiring board (4),
**characterised in that**
- the connector section (6) is mounted on the side of the cooling plate (3) opposed to the first wiring board (4),
- the second wiring board (5) is mounted between the connector section (6) and the cooling plate (3), and
- the connector pins (61) are routed to the second wiring board (5) and electrically connected with it.

2. Control unit according to Claim 1, characterised in that the connector pins (61) are electrically connected to the first wiring board (4) via conductor tracks (81) of the second wiring board (5) and the coupler elements (8).

3. Control unit according to Claim 1, characterised in that the first wiring board (4) is implemented as a hybrid circuit carrier.

4. Control unit according to Claim 1, characterised in that the cooling plate (3) and an upper housing section (1) form a housing chamber for the first wiring board (4).

5. Control unit according to Claim 1, characterised in that the cooling plate (3) and a lower housing section (2) form a housing chamber for the second wiring board (5).

6. Control unit according to Claim 1, characterised in that the cooling plate (3) has an opening (31) not overlapped by the first wiring board (4) through which the coupler elements (8) are routed.

7. Control unit according to Claim 1, characterised in that a coupler section (7) is provided which contains at least one segment of electrically conducting coupler elements (8).

8. Control unit according to Claims 6 and 7, characterised in that the coupler section (7) protrudes into the opening (31).

9. Control unit according to Claim 8, characterised in that the coupler section (7) has contact surfaces (83) which are arranged on a level with the first wiring board (4) and which are electrically connected to the coupler elements (8).

10. Control unit according to Claim 9, characterised in that bond wires (82) are routed from the contact surfaces (83) to the first wiring board (4).

11. Control unit according to Claim 5, characterised in that the second wiring board (5) is arranged on the inner side (21) of the lower housing section (2).

12. Control unit according to Claim 7, characterised in that the coupler section (7) is implemented as a contact strip (71) and contains contact pins (84) which are electrically connected to the second wiring board (5).

13. Control unit according to Claim 7, characterised in that the coupler section (7) and the second wiring board (5) are implemented in one piece as a flexible wiring board (5,7).

14. Control unit according to Claims 6 and 8, characterised in that the lower housing section (2) has a web bar (22) in the region below the opening (31), and the coupler section (7) together with the web bar (22) is routed through the opening (31).

15. Control unit according to Claims 8 and 14, characterised in that the area (72) of the coupler section (7) which contains the contact surfaces (83) is arranged on the end face (222) of the web bar (22).

16. Control unit according to Claims 8 and 15, characterised in that the coupler section (7) has an area (72) with contact surfaces, said area (72) is mounted above the first wiring board (4), and the contact surfaces (83) are electrically connected to the first wiring board (4).

17. Control unit according to Claim 1, characterised in that the upper housing section (1) together with the cooling plate (3) forms a housing chamber (1,3) the connector section (6) is electrically connected to the first wiring board (4), the cooling plate (3) is mounted between the upper housing section (1) and a lower housing section (2), the second wiring board (5) is mounted between the cooling plate (3) and the upper housing section (2), the connector section (6) is mounted below the second wiring board (5) on the lower housing section (2), and a coupler section (7) contains at least one segment of the electrically conducting coupler elements (8).

18. Control unit according to Claim 1, characterised in that the second wiring board (5) is mounted on the lower side (33) of the cooling plate (3).

19. Control unit according to Claim 1, characterised in that the connector section (6) is fixed to the cooling plate (3).

20. Control unit according to Claim 18, characterised in that the connector section (6) is fixed to the cooling plate (3) in an area (B) which is characterised by the electrical contact points between the connector pins (61) and the second wiring board (5).

21. Control unit according to Claim 1, characterised in that the connector section (6) is attached directly to the cooling plate (3).

22. Control unit according to Claim 1, characterised in that the coupler elements (8) are embodied as bond wires.

23. Control unit according to Claim 18, characterised in that the opening (31) is overlapped by the second wiring board (5), and the coupler elements (8) are routed from contact surfaces (43) on the upper side (42) of the first wiring board (4) to contact surfaces (53) on the upper side (54) of the second wiring board (5).

24. Control unit according to Claim 18, characterised in that the connector pins (61) are routed to the second wiring board (5) and the cooling plate (3) has a recess (34) in this area (B).

## Revendications

1. Appareil de commande, en particulier pour un véhicule automobile,
- comportant une plaque de refroidissement (3), sur la surface supérieure (32) de laquelle est disposée une première plaque de circuit imprimé (4) comportant une circuit électrique,
- comportant une pièce de connexion à enfichage (6) comportant des broches d'enfichage (61),
- comportant une deuxième plaque de circuit imprimé (5) qui est disposée sur la face de la plaque de refroidissement (3), opposée à la première plaque (4) de circuit imprimé, et
- comportant des éléments de raccordement (8) au moyen desquels la deuxième plaque de circuit imprimé (5) est reliée électriquement à la première plaque de circuit imprimé (4), caractérisé
- en ce que la pièce de connexion à enfichage (6) est disposée sur la face de la plaque de refroidissement (3) opposée à la première plaque de circuit imprimé (4),
- en ce que la deuxième plaque de circuit imprimé (5) est disposée entre la pièce de connexion (6) et la plaque de refroidissement (3), et
- en ce que les broches d'enfichage (61) sont guidées dans la deuxième plaque de circuit imprimé (5) et sont reliées électriquement à celle-ci.

2. Appareil de commande suivant la revendication 1, caractérisé en ce que les broches d'enfichage (61) sont reliées électriquement par des pistes conductrices (81) de la deuxième plaque de circuit imprimé (5) et par les éléments de raccordement (8), à la première plaque de circuit imprimé (4).

3. Appareil de commande suivant la revendication 1, caractérisé en ce que la première plaque de circuit imprimé (4) est réalisée sous la forme d'un support de circuit hybride.

4. Appareil de commande suivant la revendication 1, caractérisé en ce que la plaque de refroidissement (3) et une pièce supérieure de boîtier (1) constituent une chambre de boîtier pour la première plaque de circuit imprimé (4).

5. Appareil de commande suivant la revendication 1, caractérisé en ce que la plaque de refroidissement (3) et une pièce supérieure de boîtier (1) constituent une chambre de boîtier pour la deuxième plaque de circuit imprimé (5).

6. Appareil de commande suivant la revendication 1, caractérisé en ce que la plaque de refroidissement (3) présente une ouverture (31) non recouverte par la première plaque de circuit imprimé (4), ouverture par laquelle passent les éléments de raccordement (8).

7. Appareil de commande suivant la revendication 1, caractérisé en ce qu'il est prévu une pièce de liaison (7) qui comporte au moins une section d'éléments de raccordement (8) conducteurs de l'électricité.

8. Appareil de commande suivant les revendications 6 et 7, caractérisé en ce que la pièce de liaison (7) dépasse dans l'ouverture (31).

9. Appareil de commande suivant la revendication 8, caractérisé en ce que la pièce de liaison (7) présente des surfaces de contact (83) qui sont disposées sensiblement dans le même plan que la première plaque de circuit imprimé (4) et qui sont reliées électriquement aux éléments de raccordement (8).

10. Appareil de commande suivant la revendication 9, caractérisé en ce que des fils de bonding (82) relient des surfaces de contact (83) à la première plaque de circuit imprimé (4).

11. Appareil de commande suivant la revendication 5, caractérisé en ce que la deuxième plaque de circuit imprimé (5) est disposée sur la face intérieure (21) de la partie inférieure (2) du boîtier.

12. Appareil de commande suivant la revendication 7, caractérisé en ce que la pièce de liaison (7) est réalisée sous la forme d'une barrette de contact (71) et comporte des fiches de contact (84) qui sont reliées électriquement à la deuxième plaque de circuit imprimé (5).

13. Appareil de commande suivant la revendication 7, caractérisé en ce que la pièce de liaison (7) et la deuxième plaque de circuit imprimé (5) sont réalisées en une seule pièce sous la forme d'une plaque de circuit imprimé flexible (5, 7).

14. Appareil de commande suivant les revendications 6 et 8, caractérisé en ce que la partie inférieure (2) du boîtier présente, dans la zone située en-dessous de l'ouverture (31), une nervure (22), et en ce que la pièce de liaison (7), avec la nervure (22), passe au travers de l'ouverture (31).

15. Appareil de commande suivant la revendication 8 et la revendication 14, caractérisé en ce que la zone (72) de la pièce de liaison (7), zone qui contient les surfaces de contact (83), est disposée sur la face frontale (222) de la nervure (22).

16. Appareil de commande suivant la revendication 8 et la revendication 15, caractérisé en ce que la pièce de liaison (7) présente une zone (72) comportant des surfaces de contact, en ce que cette zone (72) est disposée au-dessus de la première plaque de circuit imprimé (4) et en ce que les surfaces de contact (83) sont reliées électriquement à la première plaque de circuit imprimé (4).

17. Appareil de commande suivant la revendication 1, caractérisé en ce que la partie supérieure (1) du boîtier, avec la plaque de refroidissement (3), forme une chambre de boîtier (1, 3), en ce que la pièce de connexion à enfichage (6) est reliée électriquement avec la première plaque de circuit imprimé (4), en ce que la plaque de refroidissement (3) est disposée entre la partie supérieure (1) du boîtier et une partie inférieure (2) du boîtier, en ce que la deuxième plaque de circuit imprimé (5) est disposée entre la plaque de refroidissement (3) et la partie inférieure (2) du boîtier, en ce que la pièce de connexion (6) est disposée en-dessous de la deuxième plaque de circuit imprimé (5) contre la partie inférieure (2) du boîtier et en ce qu'une pièce de liaison (7) contient au moins une section des éléments de liaison (8) conducteurs de l'électricité.

18. Appareil de commande suivant la revendication 1, caractérisé en ce que la deuxième plaque de circuit imprimé (5) est disposée sur la face inférieure (33) de la plaque de refroidissement (3).

19. Appareil de commande suivant la revendication 1, caractérisé en ce que la pièce de connexion à enfichage (6) est reliée de façon fixe à la plaque de refroidissement (3).

20. Appareil de commande suivant la revendication 18, caractérisé en ce que la pièce de connexion (6) est reliée de façon fixe à la plaque de refroidissement (3) dans une zone (B) qui est caractérisée par les points de contact électrique entre les broches d'enfichage (61) et la deuxième plaque de circuit imprimé (5).

21. Appareil de commande suivant la revendication 1, caractérisé en ce que la pièce de connexion (6) est fixée directement sur la plaque de refroidissement (3).

22. Appareil de commande suivant la revendication 1, caractérisé en ce que les éléments de raccordement (8) sont réalisés sous la forme de fils de bonding.

23. Appareil de commande suivant la revendication 18, caractérisé en ce que l'ouverture (31) est recouverte par la deuxième plaque de circuit imprimé (5) et en ce que les éléments de raccordement (8) conduisent, depuis des surfaces de contact (43) situés sur la face supérieure (42) de la première plaque de circuit imprimé (4), à des surfaces de contact (53) situées sur la face supérieure (54) de la deuxième plaque de circuit imprimé (5).

24. Appareil de commande suivant la revendication 18, caractérisé en ce que les broches d'enfichage (61) conduisent dans la deuxième plaque de circuit imprimé (5) et en ce que la plaque de refroidissement (3) présente, dans cette zone (B), un évidement (34).
